# EUROPEAN PATENT SPECIFICATION

(11) **EP 1 730 235 B1**
(45) Date of publication and mention of the grant of the patent: **29.04.2009**
(21) Application number: 05720657.5
(22) Date of filing: 07.03.2005
(51) Int. Cl.: C08L 67/00

(54) **METAL-COATED RESIN MOLDED ARTICLE AND PRODUCTION METHOD THEREFOR**
METALLBESCHICHTETER HARZFORMKÖRPER UND HERSTELLUNGSVERFAHREN DAFÜR
ARTICLE MOULÉ EN RÉSINE REVÊTUE DE MÉTAL ET PROCÉDÉ DE FABRICATION POUR CELUI-CI

(30) Priority: 10.03.2004 JP 2004068008
(43) Date of publication of application: 13.12.2006
(73) Proprietor: Panasonic Electric Works Co., Ltd., Kadoma-shi Osaka (JP); Sumitomo Chemical Company, Limited, Tokyo 104-8260 (JP)
(72) Inventor: IKEGAWA, Naoto, Matsushita Electric Works, Ltd., Kadoma-shi, Osaka 5718686 (JP); OKAMOTO, Satoshi, Sumitomo Chemical Company, Ltd., Tsukuba-shi, Ibaraki 3003294 (JP)
(74) Representative: Appelt, Christian W.
(86) International application number: PCT/JP2005/004386
(87) International publication number: WO 2005/085348

(56) References cited:
- US-A- 4 753 980
- US-B1- 6 579 943

## Description

### TECHNICAL FIELD

The present invention relates to a metal-coated resin molded using a liquid-crystalline polyester based substrate, which is preferably used in the electric and electronics industry, and a production method therefor.

### BACKGROUND ART

In the past, liquid-crystalline polyester that is excellent in electric properties and soldering heat resistance as well as chemical resistance, flame resistance and mechanical properties has been widely used as a material for electronic and mechanical parts. For example, since a circuit board obtained by forming a metal film on a resin substrate containing the liquid-crystalline polyester demonstrates good moldability, dimensional stability, high elastic modulus and strength, it also receives attention as a material for molded interconnect devices (MID).

However, there is a problem that it is difficult to obtain good adhesion of the metal film because no strong chemical bonding exist between the resin substrate and the metal film. In particular, a deterioration in adhesion of the metal film easily occurs after the circuit board receives a thermal loading

To improve this problem, for example, Japanese Patent No. 2714440 discloses a method of manufacturing a substrate for fine line circuit. In this method, a liquid-crystalline polyester resin composition is molded to obtain a resin substrate, and then the metal film is deposited on the resin substrate by sputtering, ion-plating or vacuum deposition, while heating the resin substrate in a vacuum chamber such that a surface temperature of the resin substrate is greater than 60 °C. However, there is a limitation in improving the adhesion by controlling only the deposition method of the metal film.

In addition, Japanese Patent Publication [kokoku] No. 7-24328 discloses a method of producing a molded article for fine-line circuit. In this method, a resin composition containing a liquid-crystalline polyester and an inorganic filler is molded to obtain a resin substrate, and then an etching treatment is performed to roughen a surface of the resin substrate. A metal film is formed on the roughened surface by sputtering, ion-plating or vacuum deposition. According to an anchor effect of the roughened surface and an increase in contact area between the metal film and the resin substrate, the adhesion can be improved up to a point. However, there is another problem that the formation of the fine-line circuit becomes difficult due to the increased surface roughness. In this case, a deterioration of the wiring accuracy may lead to a reduction in production yields.

US 4 753 980 discloses a resin composition for a moulded article comprising 60-97% wt of a polyester matrix and 3-40% wt of an ethylene-glycidyl ester copolymer.

### SUMMARY OF THE INVENTION

Therefore, a primary concern of the present invention is to provide a metal-coated resin molded article having improved adhesion between a metal film and a substrate made of a resin composition containing a liquid-crystalline polyester as the main component.

That is, the metal-coated resin molded article of the present invention comprises a substrate made of a resin composition and a metal layer formed on the substrate, and is characterized in that the resin composition comprises a liquid-crystalline polyester and an epoxy-group containing ethylene copolymer, the epoxy-group containing ethylene copolymer contains 50 to 99.9 wt% of an ethylene unit and 0.1 to 30 wt% of at least one of an unsaturated carboxylic acid glycidyl ester unit and an unsaturated glycidyl ether unit in the molecule thereof, and a content of said epoxy-group containing ethylene copolymer is in a range of 0.1 to 25 parts by weight with respect to 100 parts by weight of the liquid-crystalline polyester.

According to the present invention, the adhesion of the metal film can be improved by using the specific resin composition described above without subjecting the substrate to a surface roughening treatment. Consequently, it is possible to provide a molded circuit board having excellent circuit adhesion as an example of the metal-coated resin molded article.

A further concern of the present invention is to provide a method of producing a metal-coated resin molded article, which is characterized by comprising the steps of:
molding a resin composition to obtain a substrate; and
forming a metal layer on a surface of the substrate,
wherein the resin composition comprises a liquid-crystalline polyester and an epoxy-group containing ethylene copolymer, the epoxy-group containing ethylene copolymer contains 50 to 99.9 wt% of an ethylene unit and 0.1 to 30 wt% of at least one of an unsaturated carboxylic acid glycidyl ester unit and an unsaturated glycidyl ether unit in the molecule thereof, and a content of the epoxy-group containing ethylene copolymer is in a range of 0.1 to 25 parts by weight with respect to 100 parts by weight of the liquid-crystalline polyester.

To further improve the adhesion of the metal film, it is preferred that the above method comprises the step of performing a plasma treatment to the surface of the substrate prior to the formation of the metal layer. In addition, it is preferred that the metal layer is formed by physical vapor deposition.

These and further purposes and advantages of the present invention will be more clearly understood from the best mode for carrying out the invention described below.

### BRIEF EXPLANATION OF THE DRAWINGS

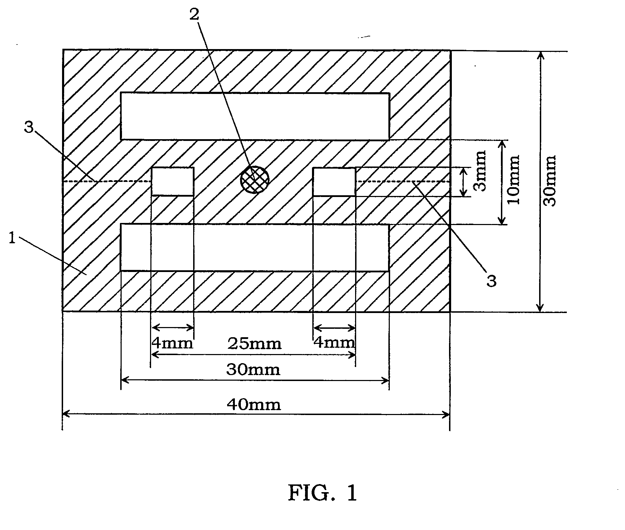

FIG. 1 is a plan view of a sample used to evaluate weldline strength performance.

### BEST MODE FOR CARRYING OUT THE INVENTION

As the liquid-crystalline polyester that is a main component of the resin composition constructing the metal-coated resin molded article of the present invention, and preferably has an aromatic skeleton forming a molten phase with optical anisotropy, for example, it is preferred to use a reaction product obtained by an ester-exchange and polycondensation reaction of at least one of an aromatic dicarboxylic acid and an aromatic hydroxycarboxylic acid, with an acylated compound obtained by acylating a phenolic hydroxyl group of at least one of an aromatic diol and an aromatic hydroxycarboxylic acid with a fatty acid anhydride.

As the aromatic diol, for example, it is possible to use 4,4'-dihydroxybiphenyl, hydroquinone, resorcin, methyl hydroquinone, chloro hydroquinone, acetoxy hydroquinone, nitro hydroquinone, 1,4-dihydroxynaphthalene, 1,5-dihydroxynaphthalene, 1,6-dihydroxynaphthalene, 2,6-dihydroxynaphthalene, 2,7-dihydroxynaphthalene, 2,2-bis(4-hydroxyphenyl) propane, 2,2-bis(4-hydroxy-3,5-dimethylphenyl) propane, 2,2-bis(4-hydroxy-3,5-dichlorophenyl) propane, 2,2-bis(4-hydroxy-3-methylphenyl) propane, 2,2-bis(4-hydroxy-3-chlorophenyl) propane, bis(4-hydroxyphenyl)methane, bis(4-hydroxy-3,5-dimethylphenyl)methane, bis(4-hydroxy-3,5-dichlorophenyl)methane, bis(4-hydroxy-3,5-dibromophenyl)methane, bis(4-hydroxy-3-methylphenyl)methane, bis(4-hydroxy-3-chlorophenyl)methane, 1,1-bis(4-hydroxyphenyl)cyclohexane, bis(4-hydroxyphenyl)ketone, bis(4-hydroxy-3,5-dimethylphenyl)ketone, bis(4-hydroxy-3,5-dichlorophenyl)ketone, bis(4-hydroxyphenyl) sulfide, or bis(4-hydroxyphenyl) sulfone. One of these compounds may be used by itself, or a combination of two or more of these compounds may be used as the aromatic diol. In particular, from the viewpoint of ready availability, it is preferred to use 4,4'-dihydroxybiphenyl, hydroquinone, resorcin, 2,6-dihydroxynaphthalene, 2,2-bis(4-hydroxyphenyl) propane or bis(4-hydroxyphenyl) sulfone.

On the other hand, as the aromatic hydroxycarboxylic acid, for example, it is possible to use parahydroxy benzoic acid, metahydroxy benzoic acid, 2-hydroxy-6-naphthoic acid, 2-hydroxy-3-naphthoic acid, 1-hydroxy-4-naphthoic acid, 4-hydroxy-4'-carboxydiphenyl ether, 2,6-dichloro-parahydroxy benzoic acid, 2-chloro-parahydroxy benzoic acid, 2,6-difluoro-parahydroxy benzoic acid, or 4-hydroxy-4'-biphenylcarboxylic acid. One of these compounds may be used by itself, or a combination of two or more of these compounds may be used as the aromatic hydroxycarboxylic acid. In particular, from the viewpoint of ready availability, it is preferred to use parahydroxy benzoic-acid or 2-hydroxy-6-naphthoic acid.

In addition, as the aromatic dicarboxylic acid, for example, it is possible to use terephthalic acid, isophthalic acid, 2,6-naphthalene dicarboxylic acid, 1,5-naphthalene dicarboxylic acid, 4,4'-biphenyldicarboxylic acid, methyl terephthalate, methyl isophthalate, diphenylether-4,4'-dicarboxylic acid, diphenylsulfone-4,4'-dicarboxylic acid, diphenylketone-4,4'-dicarboxylic acid, or 2,2'-diphenylpropane-4,4'dicarboxylic acid. One of these compounds may be used by itself, or a combination of two or more of these compounds may be used as the aromatic dicarboxylic acid. In particular, from the viewpoint of ready availability, it is preferred to use terephthalic acid, isophthalic acid or 2,6-naphthalene dicarboxylic acid.

As the fatty acid anhydride, for example, it is possible to use acetic anhydride, propionic anhydride, butyric anhydride, isobutylic anhydride, valeric anhydride, pivalic anhydride, 2-ethylhexanoic anhydride, monochloroacetic anhydride, dichloroacetic anhydride, trichloroacetic anhydride, monobromoacetic anhydride, dibromoacetic anhydride, tribromoacetic anhydride, monofluoroacetic anhydride, difluoroacetic anhydride, trifluoroacetic anhydride, glutaric anhydride, maleic anhydride, succinic anhydride or β-bromopropionic anhydride. One of these compounds may be used by itself, or a combination of two or more of these compounds may be used as the fatty acid anhydride. In particular, from the viewpoints of cost performance and ease of handling, it is preferred to use acetic anhydride, propionic anhydride, butyric anhydride, or isobutylic anhydride, and particularly acetic anhydride.

To obtain excellent adhesion between the substrate and the metal layer of the metal-coated resin molded article, it is preferred that the ester-exchange and polycondensation reaction is performed in the presence of an imidazole compound represented by the following chemical formula (1). 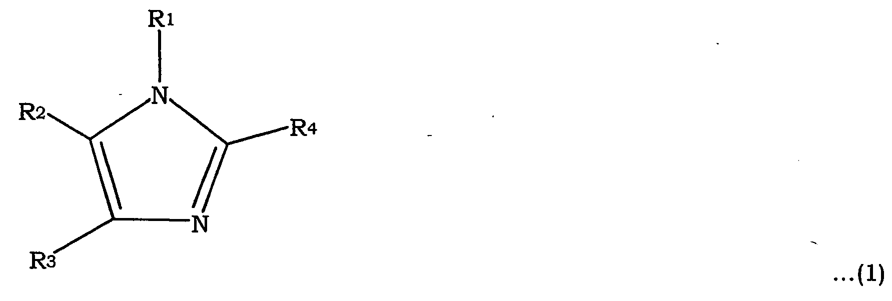 (In the formula (1), each of "R₁" to "R₄" is selected from hydrogen atom, alkyl group having a carbon number of 1 to 4, hydroxymethyl group, cyano group, cyanoalkyl group having a carbon number of 1 to 4, cyanoalkoxy group having a carbon number of 1 to 4, carboxyl group, amino group, aminoalkyl group having a carbon number of 1 to 4, aminoalkoxy group having a carbon number of 1 to 4, phenyl group, benzyl group, phenylpropyl group, and a formyl group.)

As the imidazole compound represented by the formula (1), for example, it is possible to use imidazole, 1-methylimidazole, 2-methylimidazole, 4-methylimidazole, 1-ethylimidazole, 2-ethylimidazole, 4-ethylimidazole, 1,2-dimethylimidazole, 1,4-dimethylimidazole, 2,4-dimethylimidazole, 1-methyl-2-ethylimidazole, 1-methyl-4-ethylimidazole, 1-ethyl-2-methylimidazole, 1-ethyl-2-ethylimidazole, 1-ethyl-2-phenylimidazole, 2-ethyl-4-methylimidazole, 2-phenylimidazole, 2-undecylimidazole, 2-heptadecylimidazole, 1-benzyl-2-methylimidazole, 2-phenyl-4-methylimidazole, 1-cyanoethyl-2-methylimidazole, 1-cyanoethyl-2-phenylimidazole, 4-cyanoethyl-2-ethyl-4-methylinmidazole or 1-aminoethyl-2-methylimidazole. In a particularly preferred imidazole compound, "R₁" is an alkyl group having a carbon number of 1 to 4, and "R₂" to "R₄" are hydrogen atoms. In addition, from the viewpoint of ready availability, it is preferred to use 1-methylimidazole or 2-methylimidazole.

In the above- ester-exchange and polycondensation reaction, it is preferred that amounts of the acylated compound and the aromatic dicarboxylic acid and/or the aromatic hydroxycarboxylic acid are determined such that an amount of the phenolic hydroxyl group of the aromatic diol and/or the aromatic hydroxycarboxylic acid used to prepare the acylated compound is in a range of 0.8 to 1.2 in terms of equivalent number of hydroxy group relative to carboxyl group of the aromatic dicarboxylic acid and/or the aromatic hydroxycarboxylic acid. In addition, it is preferred to proceed the ester-exchange reaction in a temperature range of from 130 °C to 400 °C, while elevating the temperature at a ratio of 0.1 to 50 °C/min, and more preferably in a temperature range of from 150 °C to 350 °C, while elevating the temperature at a ratio of 0.3 to 5 °C/min.

As the acylated compound, it is possible to use a product obtained by acylating the phenolic hydroxyl group with the fatty acid anhydride in a reaction vessel, or a compound having an acylated phenolic hydroxyl group, i.e., an fatty acid ester. It is preferred that an amount of the fatty acid anhydride is in a range of 1.0 to 1.2 and more preferably 1.05 to 1.1 in terms of equivalent number of the phenolic hydroxyl group of the aromatic diol and/or the aromatic hydroxycarboxylic acid.

When the amount of the fatty acid anhydride is less than 1.0 in terms of equivalent number of the phenolic hydroxyl group, sublimation of the raw material may be caused at the time of polymerization of the liquid-crystalline polyester due to a shift of equilibrium at the acylation toward the fatty acid anhydride. In this case, the reaction system is easily clogged. On the other hand, when the amount of the fatty acid anhydride exceeds 1.2 in terms of equivalent number of the phenolic hydroxyl group, a coloration of the obtained liquid-crystalline polyester may become a problem. In addition, it is preferred that the acylation is performed at a temperature of 130 to 180 °C for 30 minutes to 20 hours, and more preferably 140 to 160 °C for 1 to 5 hours.

To facilitate the ester-exchange reaction between the fatty acid ester and carboxylic acid through the use of a shift of equilibrium, it is preferred that by-product fatty acid and unreacted fatty acid anhydride are vaporized and removed from the reaction system. In addition, when a part of vaporized (or distilled) fatty acid is allowed to reflux in the reaction vessel, vaporized or sublimed raw material component can be returned into the reaction vessel together with the refluxed fatty acid by phenomenon of condensation or reverse sublimation.

In the ester-exchange and polycondensation reaction, it is preferred that an additive amount of the imidazole compound represented by the formula (1) is in a range of 0.005 to 1 parts by weight with respect to 100 parts by weight of a total of the aromatic dicarboxylic acid, aromatic diol, and the aromatic hydroxycarboxylic acid used to synthesize the liquid-crystalline polyester. From the viewpoints of color tone and productivity of the liquid-crystalline polyester, it is more preferred that the additive amount of the imidazole compound is in a range of 0.05 to 0.5 parts by weight. When the additive amount is less than 0.005 parts by weight, a contribution of the imidazole compound to the improvement in adhesion of the metal layer is not obtained sufficiently. On the other hand, when the additive amount exceeds 1 part by weight, it may be difficult to control the reaction system. The timing of adding the imidazole compound is not restricted on condition that the imidazole compound at least exists in the reaction system at the time of ester-exchange. Therefore, the imidazole compound may be added immediately before the ester-exchange and polycondensation reaction or in process of the reaction.

To accelerate the ester-exchange and polycondensation reaction, if necessary, a catalyst may be used. For example, the catalyst comprises a germanium compound such as germanium oxide, tin compound such as stannous oxalate, stannous acetate, dialkyl tin oxide and diaryl tin oxide, titanium compound such as titanium dioxide, titanium alkoxide and alkoxy titanium silicate, antimony compound such as antimony trioxide, metal salt of organic acid such as sodium acetate, potassium acetate, calcium acetate, zinc acetate and ferrous acetate, Lewis acid such as boron trifluoride and aluminum chloride, amines, amides, and an inorganic acid such as hydrochloric acid and sulfuric acid.

The liquid-crystalline polyester of the present invention prepared by the ester-exchange and polycondensation reaction described above has the aromatic skeleton forming the molten phase with optical anisotropy. To allow the liquid-crystalline polyester to have heat resistance and impact resistance in a balanced manner, it is preferred that the liquid-crystalline polyester contains at least 30 mol% of a repeating unit represented by the following chemical formula (2). In addition, there is no limitation in molecular weight of the liquid-crystalline polyester. For example, it is preferred that a weight-average molecular weight of the liquid-crystalline polyester is in a range of 10000 to 50000.

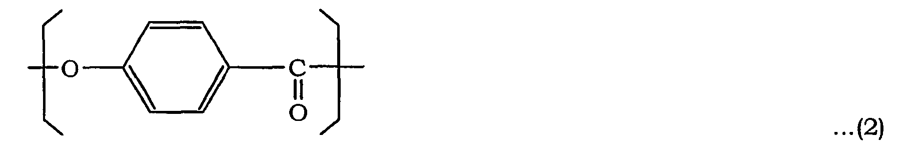

In addition, it is preferred that the repeating unit contained in the liquid-crystalline polyester is selected from the following combinations (a) to (f) based on the aromatic hydroxy carboxylic acid, aromatic dicarboxylic acid and the aromatic diol.
(a) a combination of a structural unit based on parahydroxy benzoic acid, structural unit based on terephthalic acid or a mixture of terephthalic acid and isophthalic acid, and a structural unit based on 4,4'-dihydroxybiphenyl
(b) a combination obtained by replacing a part or all of the structural unit based on 4,4'-dihydroxybiphenyl in the combination (a) with a structural unit based on hydroquinone
(c) a combination obtained by replacing a part or all of the structural unit based on 4,4'-dihydroxybiphenyl in the combination (a) with a structural unit based on resorcin
(d) a combination obtained by replacing a part or all of the structural unit based on 4,4'-dihydroxybiphenyl in the combination (a) with a structural unit based on 2,6-dihydroxynaphthalene
(e) a combination obtained by replacing a part or all of the structural unit based on 4,4'-dihydroxybiphenyl in the combination (a) with a structural unit based on a mixture of 2,6-dihydroxynaphthalene and 2,2-bis(4-hydroxyphenyl) propane
(f) a combination obtained by replacing a part or all of the structural unit based on parahydroxy benzoic acid in the combination (a) with a structural unit based on 2-hydroxy-6-naphthoic acid

Next, the epoxy-group containing ethylene copolymer is explained, which is an important component of the resin composition constructing the metal-coated resin molded article of the present invention. In the present invention, the epoxy-group containing ethylene copolymer contains 50 to 99.9 wt% of an ethylene unit and 0.1 to 30 wt% of at least one of an unsaturated carboxylic-acid glycidyl ester unit and an unsaturated glycidyl ether unit in the molecule thereof. In addition to these units, if necessary, the epoxy-group containing ethylene copolymer may contain an ethylenically unsaturated ester unit. In this case, it is preferred that an amount of the ethylenically unsaturated ester unit is 50 wt% or less.

To obtain excellent heat resistance and toughness of the resin substrate and further improve the adhesion of the metal layer, it is preferred that the epoxy-group containing ethylene copolymer contains 80 to 95 wt% of the ethylene unit and 5 to 15 wt% of at least one of the unsaturated carboxylic-acid glycidyl ester unit and the unsaturated glycidyl ether unit in the molecule thereof.

For example, compounds imparting the unsaturated carboxylic-acid glycidyl ester unit or the unsaturated glycidyl ether unit are represented by the following chemical formulas (3) and (4). 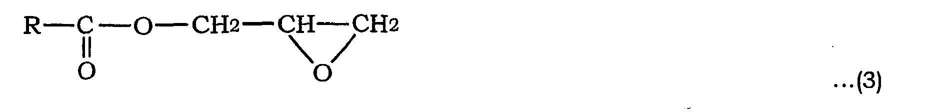 ("R" is a hydrocarbon group having a carbon number of 2 to 13 and an ethylenically unsaturated bond.) 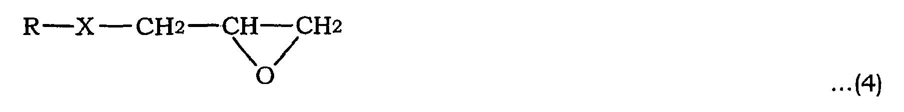 ("R" is a hydrocarbon group having a carbon number of 2 to 13 and an ethylenically unsaturated bond, and "X" is

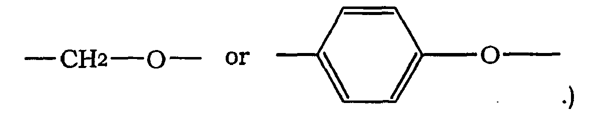

Specifically, it is possible to use glycidyl acrylate, glycidyl methacrylate, glycidyl ester of itaconic acid, allyl glycidyl ether, 2-methyl allyl glycidyl ether, or stylene-p-glycidyl ether, or the like.

As the epoxy-group containing ethylene copolymer, a ternary or more copolymer may be used, which contains an ethylenically unsaturated ester in addition to ethylene, and the unsaturated carboxylic-acid glycidyl ester and/or the unsaturated glycidyl ether. As such an ethylenically unsaturated ester compound, for example, it is possible to use a carboxylic acid vinyl ester such as vinyl acetate, vinyl propionate, methyl acrylate, ethyl acrylate, butyl acrylate, methyl methacrylate, ethyl methacrylate and butyl methacrylate, or α,β-unsaturated carboxylic acid alkyl ester. In particular, it is preferred to use vinyl acetate, methyl acrylate or ethyl acrylate.

The epoxy-group containing ethylene copolymer can be prepared by performing a copolymerization of a compound imparting the ethylene unit, compound of imparting the unsaturated carboxylic-acid glycidyl ester unit or the unsaturated glycidyl ether unit, and if necessary a compound imparting the ethylenically unsaturated ester unit under conditions of a pressure of 500 to 4000 atm and a temperature of 100 to 300 °C in the presence of a radical generating agent. If necessary, the copolymerization may be performed in the presence of an appropriate solvent or a chain transfer agent.

Specifically, as the epoxy-group containing ethylene copolymer, for example, it is possible to use a copolymer comprised of the ethylene unit and a glycidyl methacrylate unit, copolymer comprised of the ethylene unit, glycidyl methacrylate unit and a glycidyl methyl acrylate unit, copolymer comprised of the ethylene unit, glycidyl methacrylate unit and a glycidyl ethyl acrylate unit, or a copolymer comprised of the ethylene unit, glycidyl methacrylate unit and a vinyl acetate unit. In particular, it is preferred to use the copolymer comprised of the ethylene unit and the glycidyl methacrylate unit.

In addition, it is preferred that the epoxy-group containing ethylene copolymer has an melt index (MFR: JIS K7210, measuring conditions: 190 °C, 2.16 kg load) of 0.5 to 100 g/10 min, and more preferably 2 to 50 g/10 min. In this range, there is an advantage that good mechanical properties of the resin substrate and compatibility with the liquid-crystalline polyester are obtained.

In the metal-coated resin molded article of the present invention, a content of the epoxy-group containing ethylene copolymer is in a range of 0.1 to 25 parts by weight, and preferably 10 to 20 parts by weight with respect to 100 parts by weight of the liquid-crystalline polyester. When the content is less than 0.1 parts by weight, the effect of improving the adhesion between the resin substrate and the metal layer can not be obtained. On the other hand, when the content is more than 25 parts by weight, the resin substrate shows poor heat resistance, and moldability of the resin composition considerably lowers.

A metal material constructing the metal layer of the metal-coated resin molded article of the present invention is not restricted. For example, it is possible to use the metal material selected from the group essentially consisting of copper, nickel, gold, aluminum, titanium, molybdenum, chromium, tungsten, tin, lead, brass, Nichrome and an alloy thereof.

If necessary, to reinforce the resin substrate, an inorganic filler may be added to the resin composition. For example, in the case of adding a fiber-like inorganic filler such as glass fiber and carbon fiber to the resin composition, it is preferred that an additive amount of the fiber-like inorganic filler is in a range of 5 to 500 parts by weight. In this case, it is possible to increase the strength of the resin substrate, without deteriorating the adhesion of the metal layer. In addition, the occurrence of crack in weldline region of the resin substrate can be effectively prevented.

In addition, it is preferred that the fiber diameter is in a range of 6 to 15 µm, and the aspect ratio is in a range of 5 to 50. When the fiber diameter is less than 6 µm, damages of the inorganic filler easily occur at the time of dispersing the inorganic filler in the resin composition, or molding the resin composition. In addition, it becomes difficult to uniformly disperse the inorganic filler in the resin composition. On the other hand, when the fiber diameter is more than 15 µm, variations in mechanical properties of the resin substrate may become a problem due to a nonuniform distribution of the inorganic filler. In addition, it may lead to poor smoothness of the resin substrate. This poor smoothness becomes a cause of a reduction in reliability of wire bonding in the case of using the metal-coated resin molded article of the present invention as a molded circuit board. When the aspect ratio is less than 5, the effect of preventing the occurrence of cracks in weldline region decreases. On the other hand, when the aspect ratio is more than 50, damages of the inorganic filler easily occur at the time of kneading the resin composition. In addition, it may lead to a deterioration in moldability of the resin composition.

To reduce linear expansion coefficient of the resin substrate, a whisker may be used as the inorganic filler. In this case, it is preferred that the whisker has a fiber diameter of 0.5 to 5 µm and a length of 10 to 50 µm. By using the whisker, it is possible to obtain the resin molded article having excellent dimension stability and an improved surface strength of the resin substrate. This improved surface strength effectively contributes to improvements in adhesion of the metal layer, and reliability of bump bonding in the case of using the resin molded article of the present invention as the circuit board. As a material of the whisker, for example, it is possible to use silicon carbide, silicon nitride, zinc oxide, alumina, calcium titanate, potassium titanate, barium titanate, aluminum borate, calcium silicate, magnesium borate, calcium carbonate, or magnesium oxysulfate. In the case of using the titanate or borate whisker, the effect of reducing the linear expansion coefficient of the resin substrate is extremely high. In addition, when using the titanate, it is possible to reduce dielectric loss tangent of the resin substrate in addition to the improvement in adhesion of the metal layer.

In addition, when the resin composition contains short fibers such as whisker as the inorganic filler, the occurrence of an orientation of the fibers can be restrained at the time of molding the resin composition, as compared with the case of using long fibers as the inorganic filler. Therefore, the obtained resin substrate has smaller anisotropy with respect to linear expansion coefficient and shrinkage. Consequently, it is possible to minimize warpage or deformation of the resin substrate, and obtain the resin molded article having higher dimensional accuracy. In addition, the resin substrate is excellent in flatness (initial flatness) of as-molded surface of the resin substrate, and the influence of a temperature change on the flatness of the resin substrate can be reduced. To obtain the resin substrate having these advantages, while maintaining the adhesion of the metal layer, it is preferred that the an additive amount of the whisker is in a range of 20 to 235 parts by weight with respect to 100 parts by weight of the liquid-crystalline polyester. In this range, bump bonding with a high degree of reliability can be formed at the time of flip-chip bonding an IC chip to the resin substrate. In addition, good-quality pellets can be prepared by kneading a mixture of the liquid-crystalline polyester, the epoxy-group containing ethylene copolymer and the whisker by use of an extruder.

In addition, a plate-like inorganic filler such as talc, mica, glass flake, montmorillonite and smectite may be used. From the viewpoints of providing good dimensional stability and high strength of the resin substrate, it is preferred that plate-like inorganic filler has an average length of 1 to 80 µm, more preferably 1 to 50 µm, and an average aspect ratio (length/thickness) of 2 to 60, more preferably 10 to 40. From the viewpoint of preventing the anisotropy of the resin substrate to improve the dimensional stability, without deteriorating the adhesion of the metal layer, it is preferred that an additive amount of the plate-like inorganic filler is in a range of 10 to 40 parts by weight with respect to 100 parts by weight of the liquid-crystalline polyester.

The above-described fiber-like inorganic filler, whisker or the plate-like inorganic filler may be used by itself. Alternatively, a combination of two or more thereof may be used. In addition, a powder-like or needle-like inorganic filler may be added to the resin composition.

The metal-coated resin molded article of the present invention can be obtained by molding the resin composition containing the liquid-crystalline polyester, epoxy-group containing ethylene copolymer, and if necessary the inorganic filler to obtain the resin substrate, and forming the metal layer on a surface of the resin substrate.

A preparation process of the resin substrate is not restricted. To raise the effect of a heat treatment described later, it is preferred that the liquid-crystalline polyester and the epoxy-group containing ethylene copolymer are kneaded preferably at a temperature higher than a flow-beginming temperature of the liquid-crystalline polyester. In addition, it is preferred that the flow-beginning temperature of the liquid-crystalline polyester is 270 °C or more. For example, the resin substrate can be formed by kneading a mixture of the liquid-crystalline polyester having the flow-beginning temperature of 320 °C and the epoxy-group containing ethylene copolymer at 340 °C by use of a biaxial extruder to obtain pellets, and then injection molding the pellets into a desired shape. Such a pelletizing has a tendency of further increasing the adhesion of the metal layer irrespective of the presence or absence of the heat treatment, as compared with the case of not pelletizing. In the case of forming the resin substrate by injection molding, it is preferred that a melting viscosity of the resin composition is in a range of 100 to 200 poise at a shear rate of 1000/s. The flow-beginning temperature is defined as a temperature showing a melting viscosity of 48000 poise when a molten material is extruded through a nozzle under conditions of a load of 100 kgf/cm² (980 N/cm²) and a heating rate of 4 °C/min by use of a capillary rheometer with the nozzle having an inner diameter of 1 mm and a length of 10 mm. The relevant standard in Japanese Industrial Standards (JIS) is K6719-1977.

Prior to the formation of the metal layer, it is preferred to perform a heat treatment to said substrate at a temperature less than a flow-beginning temperature of the liquid-crystalline polyester, more preferably at the temperature between a lower limit temperature calculated by subtracting 120°C from the flow-beginning temperature, and an upper limit temperature calculated by subtracting 20°C from the flow-beginning temperature. In this case, it is possible to further improve the adhesion of the metal layer and reduce thermal expansion coefficient of the resin substrate. In addition, it is effective to reduce the dielectric loss tangent of the resin substrate. Consequently, the metal coated resin molded article of the present invention is preferably used as a molded circuit board having excellent RF properties. When the heat-treatment temperature is less than the lower limit temperature, the effect of the heat treatment is not obtained sufficiently. On the other hand, when the heat-treatment temperature is more than the upper limit temperature, a warpage or a deformation of the resin substrate may occur. It is also preferred that this heat treatment is performed in an inert-gas atmosphere such as nitrogen gas under a condition that the residual oxygen concentration is less than 1 %, preferably less than 0.5 %. In addition, from the viewpoint of preventing a denaturation of the resin substrate, it is preferred that the heat treatment time is in a range of from 1 to 4 hours.

In addition, prior to the formation of the metal layer, it is preferred to perform a plasma treatment to the surface of the resin substrate. When the heat treatment described above is carried out, the plasma treatment is performed after the heat treatment. Since the epoxy-group containing ethylene copolymer in the resin composition of the present invention has a high reactive functional group, the surface of the resin substrate can be effectively activated by the plasma treatment. Therefore, the effect of the plasma treatment on the improvement in adhesion of the metal layer is extremely high.

The plasma treatment can be performed by using a conventional plasma treatment apparatus. For example, a plasma treatment apparatus comprising a pair of electrodes disposed in a face-to-face relation in a chamber, and a RF unit for applying a RF electric field between the electrodes can be used. In this case, the resin substrate is placed on one of the electrodes, and the chamber is depressurized to approximately 10⁻⁴ Pa. Then, a plasma forming gas such as NH₃ and N₂ is introduced in the chamber such that the inner pressure becomes in a range of 8 to 15 Pa. Next, an RF power (13.56 WHz) of 300W is applied between the electrodes for a time period of 10 to 100 seconds by use of the RF unit to generate a plasma, so that the surface of the resin substrate is activated by cations and radicals in the generated plasma. Since a nitrogen polar group or an oxygen polar group, which has the capability of easily bonding with metal, is imparted to the surface of the resin substrate by the collision with the cations during the plasma treatment, the adhesion of the metal layer can be further improved.

The plasma treatment conditions can be arbitrarily determined on the assumption that the surface of the resin substrate is not excessively roughened by the plasma treatment. In addition, the kind of a plasma forming gas is not restricted. For example, as described above, it is preferred to use nitrogen as the plasma forming gas. In the case of using the nitrogen plasma, it is possible to reduce a desorption of carbon dioxide gas resulting from a breakage of the ester bonding of the resin substrate, as compared with the case of using an oxygen plasma. Consequently, it is possible to avoid a deterioration in strength of the surface portion of the resin substrate.

To form the metal layer, it is preferred to use physical vapor deposition such as sputtering, vacuum deposition and ion plating. In the case of performing the plasma treatment described above, it is preferred that the plasma treatment and the film formation are successively carried out without exposing the resin substrate to air

In the case of using a DC sputtering method as the sputtering, for example, the chamber having the resin substrate therein is depressurized to less than 10⁻⁴ Pa, and then an inert gas such as Ar is introduced in the chamber such that the inner pressure becomes approximately 0.1 Pa. Next, a DC voltage of 500 V is applied to bombard a copper target, so that a copper film having a thickness of 200 to 500 nm can be formed as the metal layer on the resin substrate.

In the case of using an electron-beam vacuum deposition method as the vacuum deposition, for example, the chamber having the resin substrate therein is depressurized to less than 10⁻⁴ Pa. Then, an electron flow of 400 to 800 mA is allowed to collide with a metal material in a crucible, thereby evaporating the metal material. Consequently, a copper film having a thickness of approximately 300 nm can be formed as the metal layer on the resin substrate.

In the case of using the ion plating, for example, the chamber having the resin substrate therein is depressurized to less than 10⁻⁴ Pa, and then the metal material is vaporized, as in the case of the vacuum deposition. In addition, an inert gas such as Ar is introduced between the resin substrate and a crucible such that the inner pressure becomes in a range of 0.05 to 0.1 Pa. Next, a RF power (13.56 MHz) of 500 W is applied to an induced antenna under a condition that a desired bias voltage is applied to the electrode, by which the resin substrate is supported, thereby generating a plasma in the chamber. Consequently, a copper film having a thickness of 200 to 500 nm can be formed as the metal layer on the resin substrate.

In the present invention, a particularly high adhesion strength of the metal layer can be achieved by using the resin composition of the present invention, performing the heat treatment and the plasma treatment as the pretreatments, and forming the metal layer by the PVD method such as sputtering. That is, by an effect of implanting high-energy metal particles into a surface portion of the resin substrate during the PVD method, and a chemical modification effect brought by the plasma treatment in addition to the heat-treatment effect, it is possible to obtain a strong chemical bonding at the interface between the resin substrate and the metal layer without using adhesive agents and chemicals. In addition, when deteriorations in mechanical strength and toughness of the surface portion of the resin substrate occurs, they affect on the adhesion strength of the metal layer. However, in the present invention, since the liquid-crystalline polyester is effectively reacted with the epoxy-group containing ethylene copolymer, tear resistance of the surface portion of the resin substrate can be remarkably improved. Consequently, it is possible to prevent such deteriorations in toughness and strength of the surface portion of the resin substrate. For example, when a metal foil having a thickness of several ten microns to several hundreds microns is thermal-compression bonded to the resin substrate, there is a case that Etching time is prolonged at the time of forming a circuit pattern in the metal layer, or the effect of improving the adhesion becomes small due to a poor chemical interaction with the resin substrate.

As described above, it is particularly preferred to use the metal-coated resin molded article of the present invention as the molded circuit board. In this case, a method of forming a circuit pattern in the metal layer on the resin substrate is not restricted. For example, it is recommended to use laser patterning from the viewpoint of efficiently removing unwanted metal layer other than circuit portions without deteriorating the adhesion of the metal layer. According to the present invention, since it is not needed to perform a roughening treatment for improving the adhesion of the metal layer prior to the film formation, it is possible to form a fine circuit pattern with accuracy by the laser patterning without a deterioration in wiring accuracy resulting from the formation of the metal layer on the roughened surface of the resin substrate. Therefore, the resin molded article of the present invention is also suitable for Molded Interconnect Device (MID).

After the laser patterning, an additional metal layer such as copper may be formed on the formed circuit pattern of the metal layer by electrolytic plating such that the total thickness becomes in a range of, for example, 5 to 20 µm. After the formation of the circuit pattern, a soft etching may be performed to surely remove unwanted metal layer remaining on the resin substrate, if necessary. In addition, a nickel plating layer or a gold plating layer having a thickness of several microns may be formed on the additional metal layer. Thus, the molded circuit board having a desired circuit pattern thereon can be obtained by use of the metal-coated resin molded article of the present invention.

### EXAMPLES

The present invention is concretely explained according to Examples.

### (Synthesis of Liquid-crystalline Polyester "S1")

911 g (6.6 mol) of p-hydroxybenzoic acid, 409 g (2.2 mol) of 4,4'-dihydroxybiphenyl, 274 g (1.65 mol) of terephthalic acid, 91 g (0.55 mol) of isophthalic acid, 1235 g (12.1 mol) of acetic anhydride, and 0.17 g of 1-methylimidazole were put in a reaction vessel having an agitator, torque meter, nitrogen introduction pipe, temperature gauge and a reflux condenser, and then the air in the reaction vessel was replaced by nitrogen gas. Next, the temperature of a resultant mixture was raised upto 150 °C by 15 minutes under a nitrogen gas flow, and refluxed for 3 hours at 150 °C.

Subsequently, 1.69 g of 1-methylimidazole was further added to the mixture, and then the obtained mixture was heated from 150 °C upto 320 °C by 170 minutes, while by-product acetic acid and unreacted acetic anhydride were being vaporized and removed therefrom. When an increase in torque occurred, it was regarded as the end of the reaction, and a resultant product was removed out from the reaction vessel. The solid content of the resultant product was cooled at room temperature, and crushed by a coarse grinder. Next, the temperature of the obtained powder was raised from room temperature upto 250 °C by 1 hour under a nitrogen atmosphere. In addition, it was raised from 250 °C upto 288 °C by 5 hours, and then kept at 288 °C for 3 hours to proceed the polymerization reaction in the solid state. Thus, the liquid-crystalline polyester "S1" was obtained. A flow-beginning temperature of this liquid-crystalline polyester measured by use of a flow tester ("CFT-500" manufactured by Shimadzu Corporation) is 320 °C.

### (Synthesis of Liquid-crystalline Polyester "S2")

911 g (6.6 mol) of p-hydroxybenzoic acid, 409 g (2.2 mol) of 4,4'-dihydroxybiphenyl, 274 g (1.65 mol) of terephthalic acid, 91 g (0.55 mol) of isophthalic acid, and 1235 g (12.1 mol) of acetic anhydride were put in a reaction vessel having an agitator, torque meter, nitrogen introduction pipe temperature gauge and a reflux condenser, and then the air in the reaction vessel was replaced by nitrogen gas. In this synthesis, no imidazole compound was used. Next, the temperature of a resultant mixture was raised upto 150 °C by 15 minutes under a nitrogen gas flow, and refluxed for 3 hours at 150 °C.

Next, the temperature of the resultant mixture was raised from 150 °C upto 320 °C by 170 minutes, while by-product acetic acid and unreacted acetic anhydride were being vaporized and removed therefrom. When an increase in torque occurred, it was regarded as the end of the reaction, and a resultant product was removed out from the reaction vessel. The solid content of the resultant product was cooled at room temperature, and then crushed by a coarse grinder. Subsequently, the temperature of the obtained powder was raised from room temperature upto 250 °C by 1 hour under a nitrogen atmosphere. In addition, it was raised from 250 °C upto 278 °C by 5 hours, and then kept at 278 °C for 3 hours to proceed the polymerization reaction in the solid state. Thus, the liquid-crystalline polyester "S2" was obtained. A flow-beginning temperature of this liquid-crystalline polyester measured by use of the flow tester is 320 °C.

On the other hand, as the epoxy-group containing ethylene copolymer, Bond First@ "BF-E", "BF-2C", "BF-7M" and "BF-2B" (manufactured by SUMITOMO CHEMICAL Co., Ltd.) were used. The Bond First@ "BF-E" is an ethylene-glycidyl methacrylate copolymer (the content of glycidyl methacrylate: 12. wt%, MFR = 3 g/10 minutes). The Bond First@ "BF-2C" is an ethylene-glycidyl methacrylate copolymer (the content of glycidyl methacrylate: 6 wt%, MFR = 3 g/10 minutes). The Bond First@ "BF-7M" is an ethylene-glycidyl methacrylate-methyl acrylate copolymer (the content of glycidyl methacrylate: 6 wt%, the content of methyl acrylate: 30 wt%, MFR = 9 g/10 minutes). The Bond First@ "BF-2B" is an ethylene-glycidyl methacrylate-vinyl acetate copolymer (the content of glycidyl methacrylate: 12 wt%, the content of vinyl acetate: 5 wt%, MFR = 3 g/10 minutes). The MFR (Melt Flow Rate) value was measured at the temperature of 190 °C under the load of 2160 g according to JIS(Japanese Industrial Standards) K7210.

If necessary, as an inorganic filler, a milled glass fiber (MGF: "EFH-7501" manufactured by CENTRAL GLASS CO., LTD., fiber diameter: 10µm, aspect ratio: 10), aluminum borate whisker "ALBOREX YS3A" (manufactured by Shikoku Corp., fiber diameter: 0.5 to 1.0 µm, length: 10 to 30 µm), and/or a talc "X-50" (manufactured by NIPPON TALC CO., LTD., average length: 20 to 25 µm, aspect ratio: 5 to 10) was used.

### (Example 1)

100 parts by weight of the liquid-crystalline polyester "S1" was mixed with 5 parts by weight of the epoxy-group containing ethylene copolymer "BF-E" and 67 parts by weight of the milled glass fiber (MGF) "EFH-7501" as the inorganic filler to obtain a resin composition. Next, pellets of this resin composition were prepared at 340 °C by using a twin Screw Extruder ("PCM-30" manufactured by Ikegai Tekko). The prepared pellets were injection molded at a cylinder temperature of 350 °C and a mold temperature of 130 °C by using an injection molding machine ("PS40E5ASE" manufactured by Nissei Plastic Industrial Co., Ltd.), to obtain a resin substrate having the dimensions of 40 mm x 30 mm x 1mm.

After a plasma treatment was performed to a surface of the resin substrate, a metal layer was formed thereon by using a DC magnetron sputtering apparatus. That is, the resin substrate was placed in a chamber of plasma treatment apparatus, and then the chamber was evacuated to approximately 10⁻⁴ Pa. In addition, nitrogen gas was introduced into the chamber such that the gas pressure in the chamber is 10 Pa, and then the plasma treatment was performed to the resin substrate in the chamber by applying a RF (13.56 MHz) power of 300 W between electrodes of the plasma treatment apparatus for 30 seconds.

After the plasma treatment, the chamber was evacuated to less than approximately 10⁻⁴ Pa. Under this condition, argon gas was introduced into the chamber such that the gas pressure in the chamber is 0.1 Pa, and then a copper target was bombarded by applying a DC voltage of 500 V to form a copper film having the thickness of 400 nm on the plasma-treated surface of resin substrate.

Next, a pattern having the width of 5 mm was formed in the metal layer by laser irradiation, and copper was plated on the pattern of the metal layer by electrolytic plating to obtain a circuit pattern for peel strength test having the thickness of 15 µm on the resin substrate.

### (Examples 2 to 5)

In each of Examples 2 to 5, a resin substrate having the circuit pattern for peel strength test was produced according to a substantially same method as Example 1 except for using a different amount of the epoxy-group containing ethylene copolymer "BF-E", as listed in Table 1.

### (Example 6)

A resin substrate having the circuit pattern for peel strength test was produced according to a substantially same method as Example 1 except that 100 parts by weight of the liquid-crystalline polyester "S2" was mixed with 10 parts by weight of the epoxy-group containing ethylene copolymer "BF-E" and 67 parts by weight of the milled glass fiber (MGF) "EFH-7501" to obtain the resin composition.

### (Example 7)

A resin substrate having the circuit pattern for peel strength test was produced according to a substantially same method as Example 1 except for using 15 parts by weight of the epoxy-group containing ethylene copolymer "BF-2C" in the place of "BF-E".

### (Example 8)

A resin substrate having the circuit pattern for peel strength test was produced according to a substantially same method as Example 1 except for using 15 parts by weight of the epoxy-group containing ethylene copolymer "BF-7M" in the place of "BF-E".

### (Example 9)

A resin substrate having the circuit pattern for peel strength test was produced according to a substantially same method as Example 1 except for using 15 parts by weight of the epoxy-group containing ethylene copolymer "BF-2B" in the place of "BF-E".

### (Comparative Example 1)

A resin substrate having the circuit pattern for peel strength test was produced according to a substantially same method as Example 1 except for not using the epoxy-group containing ethylene copolymer.

With respect to each of Examples 1 to 9 and Comparative Example 1, 90 degree peel strength of the circuit pattern was measured by using a universal testing machine ("EG Test" manufactured by Shimadzu Corporation). In addition, deflection temperature under load (DTUL) was measured under the load of 1.82 MPa according to ASTM D648. Results are shown in Table 1.

**TABLE 1**

| | Examples | | | | | | | | | Comparative Example |
|---|---|---|---|---|---|---|---|---|---|---|
| | 1 | 2 | 3 | 4 | 5 | 6 | 7 | 8 | 9 | 1 |
| Liquid Crystalline Polyester (parts by weight) | S1 | S1 | S1 | S1 | S1 | S2 | S1 | S1 | S1 | S1 |
| | 100 | 100 | 100 | 100 | 100 | 100 | 100 | 100 | 100 | 100 |
| Epoxy-group containing Ethylene Copolymer (parts by weight) | BF-E 5 | BF-E 10 | BF-E 15 | BF-E 20 | BF-E 25 | BF-E 10 | BF-2C 15 | BF-7M 15 | BF-2B 15 | None |
| Inorganic Filler (MGF) (parts by weight) | 67 | 67 | 67 | 67 | 67 | 67 | 67 | 67 | 67 | 67 |
| Peel Strength (N/mm) | 0.36 | 0.42 | 0.40 | 0.39 | 0.43 | 0.36 | 0.41 | 0.40 | 0.38 | 0.29 |
| DTUL (°C) | 266.0 | 259.6 | 255.4 | 243.9 | 232.0 | 258.0 | 266.0 | 232.0 | 255.4 | 279.0 |

As understood from the results of Table 1, the adhesion of the circuit pattern in each of Examples 1 to 9 is greater than that of the circuit pattern in Comparative Example 1, in which the epoxy-group containing ethylene copolymer was not used. In addition, a comparison between Examples 2 and 6 indicates that a further improvement in adhesion is achieved in the case of using the liquid-crystalline polyester "S1" synthesized in the presence of the imidazole compound. Moreover, the DTUL of the resin substrate of each of Examples 3, 7 and 9, in which the epoxy-group containing ethylene copolymer having larger than 80 wt% of the ethylene unit in the molecule was used, is higher than that of the resin substrate of Example 8, in which the epoxy-group containing ethylene copolymer having smaller than 80 wt% of the ethylene unit in the molecule was used. Therefore, from the viewpoint of improving the heat resistance, it is preferred to use the epoxy-group containing ethylene copolymer having larger than 80 wt% of the ethylene unit in the molecule.

### (Examples 10 to 13)

In each of Examples 10 to 13, a resin substrate having the circuit pattern for peel strength test was produced according to a substantially same method as Example 1 except that the additive amount of the epoxy-group containing ethylene copolymer "BF-E" is 10 parts by weight, and a heat treatment was performed to the resin substrate under the conditions shown in Table 2 prior to the plasma treatment.

### (Comparative Example 2)

A resin substrate having the circuit pattern for peel strength test was produced according to a substantially same method as Example 1 except that the epoxy-group containing ethylene copolymer was not used, and a heat treatment was performed to the resin substrate under the conditions shown in Table 2 prior to the plasma treatment.

**TABLE 2**

| | Examples | | | | | Comparative Examples | |
|---|---|---|---|---|---|---|---|
| | 10 | 11 | 12 | 13 | 2 | 1 | 2 |
| Liquid Crystalline Polyester | S 1 | S 1 | S 1 | S 1 | S 1 | S 1 | S 1 |
| (parts by weight) | 100 | 100 | 100 | 100 | 100 | 100 | 100 |
| Epoxy-group containing | BF-E | BF-E | BF-E | BF-E | BF-E | None | None |
| Ethylene Copolymer (parts by weight) | 10 | 10 | 10 | 10 | 10 | | |
| Inorganic Filler (MGF) (parts by weight) | 67 | 67 | 67 | 67 | 67 | 67 | 67 |
| Heat Treatment Conditions | 300°C, 3hrs, N₂ | 260°C, 3hrs, N₂ | 240°C, 3hrs, N₂ | 200°C, 3hrs, N₂ | None | None | 270°C, 3hrs, N₂ |
| Peel Strength (N/mm) | 0.53 | 0.49 | 0.45 | 0.43 | 0.42 | 0.29 | 0.26 |
| Dielectric Loss tan δ (x 10⁻³) | 5.13 | 5.22 | 5.46 | 6.00 | 6.73 | 5.18 | 5.48 |
| DTUL (°C) | >300 | 290 | 278 | 265.5 | 259.6 | 279.0 | --- |
| Heat Resistance Temperature (°C) | 330 | 310 | 310 | 310 | 300 | 310 | --- |

With respect to each of Examples 10 to 13, the 90 degree peel strength of the circuit pattern and the deflection temperature under load (DTUL) of the resin substrate were measured, as in the case of Example 1. In addition, with respect to Examples 2 and 10 to 13, soldering heat resistance of the resin substrate was evaluated according to the following method. That is, after a sample of the resin substrate was dipped in a soldering bath for 60 seconds, the occurrence of deformation was checked. A minimum soldering bath temperature causing the deformation was determined as the heat resistance temperature. Moreover, with respect to Examples 2, 10 to 13 and Comparative Examples 1 and 2, the dielectric loss tangent (tan δ) at 1 GHz of the resin substrate was determined by performing an impedance measurement according to the RF I-V method by use of a RF impedance/material analyzer "HP 4291A". In Comparative Example 2, the DTUL and the heat resistance temperature were not measured. Results are shown in Table 2.

As understood from comparisons between Example 2 and Examples 10 to 13, the adhesion of the circuit pattern and the soldering heat resistance are further improved by the heat treatment, and the dielectric loss tangent (tan δ) is reduced by the heat treatment. In addition, the results of Comparative Examples 1 and 2 show that when the resin substrate doe not contain the epoxy-group containing ethylene copolymer, there is a case that the dielectric loss tangent (tan δ) is increased by the heat treatment.

### (Example 14)

A resin substrate having the circuit pattern for peel strength test was produced according to a substantially same method as Example 1 except that 100 parts by weight of the liquid-crystalline polyester "S1" was mixed with 10 parts by weight of the epoxy-group containing ethylene copolymer "BF-E", 30 parts by weight of the milled glass fiber (MGF) "EFH-7501", 50 parts by weight of the aluminum borate whisker "ALBOREX YS3A", and 20 parts by weight of the talc "X-50" to obtain the resin composition.

### (Examples 15 to 21)

In each of Examples 15 to 21, a resin substrate having the circuit pattern for peel strength test was produced according to a substantially same method as Example 14 except for using the milled glass fiber (MGF) having different diameter and aspect ratio, as shown in Table 3.

With respect to Examples 14 to 21, weldline strength performance of the resin substrate was evaluated. That is, as shown in FIG. 1, a test sample 1 (thickness: 0.6 mm) of the resin substrate was prepared by injection molding. In FIG. 1, the numeral "2" designates a pin gate (φ: 3mm), and the numeral "3" designates the weldline. After a heat treatment was performed to the test sample at 250 °C for 3 hours in a nitrogen substituted atmosphere, the weldline strength performance was evaluated according to the following criteria.
- O :: There was no occurrence of crack.
- × :: Crack occurred after the heat treatment.

In addition, after the heat treatment, the 90 degree peel strength of the circuit pattern was measured according to the same manner as Example 1. Results are shown in Table 3.

As understood from the results of Table 3, good adhesion of the circuit pattern was obtained in each of Examples 14 to 21. In addition, comparisons between Examples 14 to 18 and Examples 19 to 21 show that it is preferred to use the fiber-like inorganic filler having a fiber diameter of 6 to 15 µm and an aspect ratio of 5 to 50 to obtain good weldline strength performance.

**TABLE 3**

| | | Examples | | | | | | | |
|---|---|---|---|---|---|---|---|---|---|
| | | 14 | 15 | 16 | 17 | 18 | 19 | 20 | 21 |
| Liquid Crystalline Polyester (parts by weight) | | S 1 | S 1 | S 1 | S 1 | S 1 | S 1 | S 1 | S 1 |
| | | 100 | 100 | 100 | 100 | 100 | 100 | 100 | 100 |
| Epoxy-group containing Ethylene Copolymer (parts by weight) | | BF-E | BF-E | BF-E | BF-E | BF-E | BF-E | BF-E | BF-E |
| | | 10 | 10 | 10 | 10 | 10 | 10 | 10 | 10 |
| Inorganic Filler (parts by weight) | MGF: | 30 | 30 | 30 | 30 | 30 | 30 | 30 | 30 |
| | Diameter: | φ10µm | φ10µm | φ10µm | φ6µm | φ15µm | φ10µm | φ10µm | φ20µm |
| | Aspect Ratio: | 5 | 10 | 50 | 10 | 10 | 3 | 100 | 10 |
| | Whisker: | 50 | 50 | 50 | 50 | 50 | 50 | 50 | 50 |
| | Talc: | 20 | 20 | 20 | 20 | 20 | 20 | 20 | 20 |
| Peel Strength (N/mm) | | 0.37 | 0.41 | 0.41 | 0.43 | 0.39 | 0.33 | 0.43 | 0.33 |
| Weldline Strength Performance | | ○ | ○ | ○ | ○ | ○ | × | × | × |

### (Examples 22 to 26)

In each of Examples 22 to 26, a resin substrate having the circuit pattern for peel strength test was produced according to a substantially same method as Example 1 except that 100 parts by weight of the liquid-crystalline polyester "S1" was mixed with 10 parts by weight of the epoxy-group containing ethylene copolymer "BF-E", and an amount shown in Table 4 of the aluminum borate whisker "ALBOREX YS3A" to obtain the resin composition.

### (Examples 27 to 31)

In each of Examples 27 to 31, a resin substrate having the circuit pattern for peel strength test was produced according to a substantially same method as Example 1 except that 100 parts by weight of the liquid-crystalline polyester "S1" was mixed with 10 parts by weight of the epoxy-group containing ethylene copolymer "BF-E", amount shown in Table 4 of the aluminum borate whisker "ALBOREX YS3A", and an amount shown in Table 4 of the talc "X-50" to obtain the resin composition.

With respect to Examples 22 to 31, after a heat treatment was performed to the resin substrate at 250 °C for 3 hours in a nitrogen substituted atmosphere, the 90 degree peel strength of the circuit pattern was measured according to the same manner as Example 1. In addition, linear expansion coefficient of the resin substrate was determined according to the following method. That is, a test piece was cut out from a center portion of an injection molded article having the dimensions of 80 mm x 80 mm x 3 mm made of the resin composition, so that a size in the resin flow direction (MD) of the test piece is 5mm, and a size in a direction (TD) orthogonal to the resin flow direction is 10 mm. Then, a TMA measurement was performed to the test piece to determine the linear expansion coefficient. Results are shown in Table 4.

**TABLE 4**

| | Examples | | | | | | | | | |
|---|---|---|---|---|---|---|---|---|---|---|
| | 22 | 23 | 24 | 25 | 26 | 27 | 28 | 29 | 30 | 31 |
| Liquid Crystalline Polyester (parts by weight) | S1 | S1 | S1 | S1 | S1 | S1 | S1 | S1 | S1 | S1 |
| | 100 | 100 | 100 | 100 | 100 | 100 | 100 | 100 | 100 | 100 |
| Epoxy-group containing | BF-E | BF-E | BF-E | BF-E | BF-E | BF-E | BF-E | BF-E | BF-E | BF-E |
| Ethylene Copolymer (parts by weight) | 10 | 10 | 10 | 10 | 10 | 10 | 10 | 10 | 10 | 10 |
| Inorganic Filler (Whisker) (parts by weight) | 20 | 67 | 100 | 235 | 290 | 90 | 80 | 70 | 60 | 50 |
| Inorganic Filler (Talc) (parts by weight) | 0 | 0 | 0 | 0 | 0 | 10 | 20 | 30 | 40 | 50 |
| Peel Strength (N/mm) | 0.45 | 0.43 | 0.43 | 0.33 | 0.30 | 0.45 | 0.44 | 0.38 | 0.33 | 0.30 |
| Linear Expansion Coefficient (MD/TD) x10⁻³/°C | 19/28 | 13/18 | 9/14 | 7/12 | 5/10 | 10/13 | 12/14 | 13/16 | 15/18 | 18/18 |

As understood from the results of Examples 22 to 26, it is preferred that the additive amount of the whisker is in the range of 20 to 235 parts by weight with respect to 100 parts by weight of the liquid-crystalline polyester to from the viewpoint of reducing the linear expansion coefficient, while maintaining good adhesion of the circuit pattern. With respect to Examples 27 to 31 containing both of the whisker and the talc, there is a tendency that a difference in linear expansion coefficient between the resin flow direction (MD) and the orthogonal direction (TD) becomes smaller as the talc amount increases. This suggests that the anisotropy of linear expansion coefficient can be reduced by adding the talc. However, from the viewpoint of achieving the low linear expansion coefficient and good adhesion of the circuit pattern in a balanced manner, it is preferred that the additive amount of the talc is 10 to 40 parts by weight with respect to 100 parts by weight of the liquid-crystalline polyester.

### INDUSTRIAL APPLICABILITY

As shown in the above Examples, the present invention provides the metal-coated resin molded article having excellent adhesion of the metal film. In addition, when a heat treatment is performed to the resin substrate, it is possible to obtain the metal-coated resin molded article having both of the improved adhesion and a reduced dielectric loss tangent. Therefore, the resin molded article of the present invention having these advantages will be preferably used in the electric and electronics industry, and particularly in the technical field requiring high-frequency performance.

## Claims

1. A metal-coated resin molded article comprising a substrate made of a resin composition and a metal layer formed on said substrate, wherein said resin composition comprises a liquid-crystalline polyester and an epoxy-group containing ethylene copolymer,
said epoxy-group containing ethylene copolymer contains 50 to 99.9 wt% of an ethylene unit and 0.1 to 30 wt% of at least one of an unsaturated carboxylic acid glycidyl ester unit and an unsaturated glycidyl ether unit in the molecule thereof, and
a content of said epoxy-group containing ethylene copolymer is in a range of 0.1 to 25 parts by weight with respect to 100 parts by weight of said liquid-crystalline polyester.

2. The metal-coated resin molded article as set forth in claim 1, wherein said liquid-crystalline polyester is a reaction product obtained by an ester-exchange and polycondensation reaction of at least one of an aromatic dicarboxylic acid and an aromatic hydroxycarboxylic acid with an acylated compound obtained by acylating a phenolic hydroxyl group of at least one of an aromatic diol and an aromatic hydroxycarboxylic acid with a fatty acid anhydride.

3. The metal-coated resin molded article as set forth in claim 1, wherein said liquid-crystalline polyester is the reaction product obtained by performing the ester-exchange and polycondensation reaction in the presence of an imidazole compound represented by the following chemical formula: 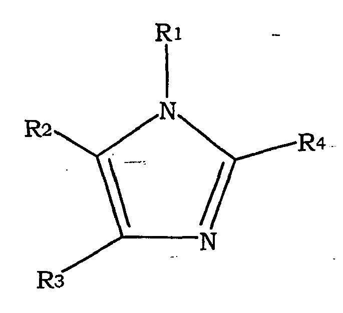 wherein, each of "R₁" to "R₄" is selected from hydrogen atom, alkyl group having a carbon number of 1 to 4, hydroxymethyl group, cyano group, cyanoalkyl group having a carbon number of 1 to 4, cyanoalkoxy group having a carbon number of 1 to 4, carboxyl group, amino group, aminoalkyl group having a carbon number of 1 to 4, aminoalkoxy group having a carbon number of 1 to 4, phenyl group, benzyl group, phenylpropyl group, and a formyl group.

4. The metal-coated resin molded article as set forth in claim 1, wherein said epoxy-group containing ethylene copolymer contains 80 to 95 wt% of the ethylene unit and 5 to 15 wt% of at least one of the unsaturated carboxylic acid glycidyl ester unit and the unsaturated glycidyl ether unit in the molecule thereof.

5. The metal-coated resin molded article as set forth in claim 1, wherein said resin composition contains a fiber-like inorganic filler having a diameter of 6 to 15 µm and an aspect ratio of 5 to 50.

6. The metal-coated resin molded article as set forth in claim 1, wherein said resin composition contains 20 to 235 parts by weight of a whisker with respect to 100 parts by weight of said liquid-crystalline polyester.

7. The metal-coated resin molded article as set forth in claim 1, wherein said resin composition contains 10 to 40 parts by weight of a plate-like inorganic filler with respect to 100 parts by weight of said liquid-crystalline polyester.

8. The metal-coated resin molded article as set forth in claim 1, wherein said metal layer is made of a metal material selected from the group essentially consisting of copper, nickel, gold, aluminum, titanium, molybdenum, chromium, tungsten, tin, lead, brass, Nichrome and an alloy thereof.

9. The metal-coated resin molded article as set forth in claim 1, wherein said metal layer is formed in a circuit pattern.

10. A method of producing a metal-coated resin molded article comprising the steps of
molding a resin composition to obtain a substrate; and
forming a metal layer on a surface of said substrate,
wherein said resin composition comprises a liquid-crystalline polyester and an epoxy-group containing ethylene copolymer, said epoxy-group containing ethylene copolymer contains 50 to 99.9 wt% of an ethylene unit and 0.1 to 30 wt% of at least one of an unsaturated carboxylic acid glycidyl ester unit and an unsaturated glycidyl ether unit in the molecule thereof, and a content of said epoxy-group containing ethylene copolymer is in a range of 0.1 to 25 parts by weight with respect to 100 parts by weight of said liquid-crystalline polyester.

11. The method as set forth in claim 10 comprising the step of performing a plasma treatment to the surface of said substrate prior to the formation of said metal layer.

12. The method as set forth in claim 10, wherein said metal layer is formed by physical vapor deposition.

13. The method as set forth in claim 10 comprising the step of performing a heat treatment to said substrate at a temperature between a lower limit temperature calculated by subtracting 120°C from a flow-beginning temperature of said liquid-crystalline polyester, and an upper limit temperature calculated by subtracting 20°C from the flow-beginning temperature.

14. The method as set forth in claim 10, wherein said liquid-crystalline polyester is prepared by an ester-exchange and polycondensation reaction of at least one of an aromatic dicarboxylic acid and an aromatic hydroxycarboxylic acid, with an acylated compound obtained by acylating a phenolic hydroxyl group of at least one of an aromatic diol and an aromatic hydroxycarboxylic acid with a fatty acid anhydride.

15. The method as set forth in claim 14, wherein the ester-exchange and polycondensation reaction is performed in the presence of an imidazole compound represented by the following chemical formula: 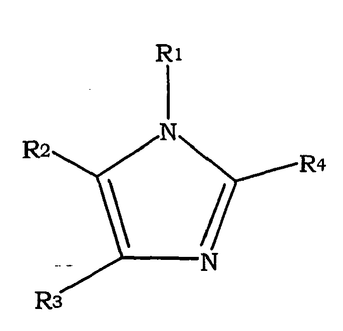 wherein, each of "R₁" to "R₄" is selected from hydrogen atom, alkyl group having a carbon number of 1 to 4, hydroxymethyl group, cyano group, cyanoalkyl group having a carbon number of 1 to 4, cyanoalkoxy group having a carbon number of 1 to 4, carboxyl group, amino group, aminoalkyl group having a carbon number of 1 to 4, aminoalkoxy group having a carbon number of 1 to 4, phenyl group, benzyl group, phenylpropyl group, and a formyl group.

16. The method as set forth in claim 10 comprising the step of forming a circuit pattern in said metal layer by laser patterning.

## Patentansprüche

1. Metallbeschichteter Harzformartikel, umfassend ein Substrat, das aus einer Harzzusammensetzung gemacht ist, und eine Metallschicht, die auf dem Substrat gebildet ist, wobei die Harzzusammensetzung einen flüssigkristallinen Polyester und ein Epoxygruppenenthaltendes Ethylen-Copolymer umfasst,
wobei das Epoxygruppen-enthaltende Ethylen-Copolymer 50 bis 99,9 Gew.% einer Ethyleneinheit und 0,1 bis 30 Gew.% von wenigstens einer aus einer ungesättigten Carbonsäure-Glycidylester-Einheit und einer ungesättigten Glycidylether-Einheit im Molekül enthält, und
ein Gehalt des Epoxygruppen-enthaltenden Ethylen-Copolymers in einem Bereich von 0,1 bis 25 Gewichtsteile, bezogen auf 100 Gewichtsteile des flüssigkristallinen Polyester, beträgt.

2. Metallbeschichteter Harzformartikel nach Anspruch 1, wobei der flüssigkristalline Polyester ein Reaktionsprodukt ist, erhalten durch eine Ester-Austausch- und Polykondensations-Reaktion von wenigstens einer aromatischen Dicarbonsäure und einer aromatischen Hydroxycarbonsäure mit einer acylierten Verbindung, erhalten durch Acylieren einer phenolischen Hydroxylgruppe von wenigstens einem aromatischen Diol und einer aromatischen Hydroxycarbonsäure mit einem Fettsäureanhydrid.

3. Metallbeschichteter Harzformartikel nach Anspruch 1, wobei der flüssigkristalline Polyester das Reaktionsprodukt ist, das durch Durchführen der Ester-Austausch- und Polykondensations-Reaktion in der Anwesenheit einer Imidazol-Verbindung erhalten wird, dargestellt durch die folgende chemische Formel: 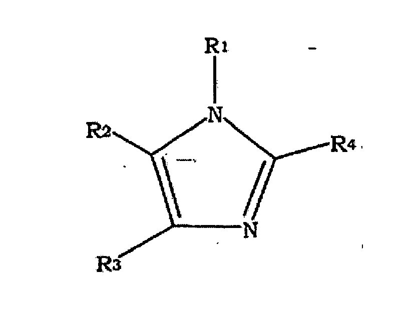 wobei jedes von "R₁" bis "R₄" ausgewählt ist aus Wasserstoffatom, Alkylgruppe mit einer Kohlenstoffanzahl von 1 bis 4, Hydroxymethylgruppe, Cyanogruppe, Cyanoalkylgruppe, mit einer Kohlenstoffanzahl von 1 bis 4, Cyanoalkoxygruppe mit einer Kohlenstoffanzahl von 1 bis 4, Carboxylgruppe, Aminogruppe, Aminoalkylgruppe mit einer Kohlenstoffanzahl von 1 bis 4, Aminoalkoxygruppe mit einer Kohlenstoffanzahl von 1 bis 4, Phenylgruppe, Benzylgruppe, Phenylpropylgruppe und einer Formylgruppe.

4. Metallbeschichteter Harzformartikel nach Anspruch 1, wobei das Epoxygruppen-enthaltende Ethylencopolymer 80 bis 95 Gew.% der Ethyleneinheit und 5 bis 15 Gew. % von wenigstens einer aus der ungesättigten Carbonsäureglycidylestereinheit und der ungesättigten Glycidylethereinheit im Molekül enthält.

5. Metallbeschichteter Harzformartikel nach Anspruch 1, wobei die Harzzusammensetzung einen faserartigen anorganischen Füllstoff mit einem Durchmesser von 6 bis 15 µm und einem Querschnittsverhältnis ("aspect ratio") von 5 bis 50 enthält.

6. Metallbeschichteter Harzformartikel nach Anspruch 1, wobei die Harzzusammensetzung 20 bis 235 Gewichtsteile eines Haarkristalls ("whisker"), bezogen auf 100 Gewichtsteile des flüssigkristallinen Polyesters enthält.

7. Metallbeschichteter Harzformartikel nach Anspruch 1, wobei die Harzzusammensetzung 10 bis 40 Gewichtsteile eines plattenartigen anorganischen Füllstoffs, bezogen auf 100 Gewichtsteile des flüssigkristallinen Polyesters, enthält.

8. Metallbeschichteter Harzformartikel nach Anspruch 1, wobei die Metallschicht aus einem Metallmaterial gemacht ist, ausgewählt aus der Gruppe, bestehend im wesentlichen aus Kupfer, Nickel, Gold, Aluminium, Titan, Molybdän, Chrom, Wolfram, Zinn, Blei, Messing, Nichrom und eine Legierung davon.

9. Metallbeschichteter Harzformartikel nach Anspruch 1, wobei die Metallschicht in einem Schaltkreismuster gebildet ist.

10. Verfahren zum Herstellen eines metallbeschichteten Harzformartikels, umfassend die Schritte:
Formen einer Harzzusammensetzung, um ein Substrat zu erhalten, und
Bilden einer Metallschicht auf einer Oberfläche des Substrats,
wobei die Harzzusammensetzung einen flüssigkristallinen Polyester und ein Epoxygruppen-enthaltendes Ethylen-Copolymer umfasst, wobei das Epoxygruppen-enthaltende Ethylen-Copolymer 50 bis 99,9 Gew. % einer Ethyleneinheit und 0,1 bis 30 Gew. % von wenigstens einer aus einer ungesättigten Carbonsäure-Glycidylester-Einheit und einer ungesättigten Glycidylether-Einheit im Molekül enthält, und ein Gehalt von dem Epoxygruppen-enthaltenden Ethylen-Copolymer in einem Bereich von 0,1 bis 25 Gewichtsteile, bezogen auf 100 Gewichtsteile des flüssigkristallinen Polyesters, beträgt.

11. Verfahren nach Anspruch 10, umfassend den Schritt der Durchführung einer Plasmabehandlung der Oberfläche des Substrats vor der Bildung der Metallschicht.

12. Verfahren nach Anspruch 10, wobei die Metallschicht durch physikalische Gasphasenabscheidung ("physical vapor deposition") gebildet wird.

13. Verfahren nach Anspruch 10, umfassend den Schritt der Durchführung einer Wärmebehandlung des Substrat bei einer Temperatur zwischen einer unteren Temperaturgrenze, berechnet durch Subtrahieren von 120 °C von einer Fluss-beginnenden Temperatur des flüssigkristallinen Polyesters, und einer oberen Temperaturgrenze, berechnet durch Subtrahieren von 20 °C von der Fluss-beginnenden Temperatur.

14. Verfahren nach Anspruch 10, wobei der flüssigkristalline Polyester durch eine Ester-Austausch- und Polykondensations-Reaktion von wenigstens einer aus einer aromatischen Dicarbonsäure und einer aromatischen Hydroxycarbonsäure mit einer acylierten Verbindung hergestellt wird, wobei die acylierte Verbindung durch Acylieren einer phenolischen Hydroxylgruppe von wenigstens einem aus einem aromatischen Diol und einer aromatischen Hydroxycarbonsäure mit einem Fettsäureanhydrid erhalten wird.

15. Verfahren nach Anspruch 14, wobei die Esteraustausch- und Polykondensationsreaktion in der Anwesenheit einer Imidazolverbindung durchgeführt wird, dargestellt durch die folgende chemische Formel: 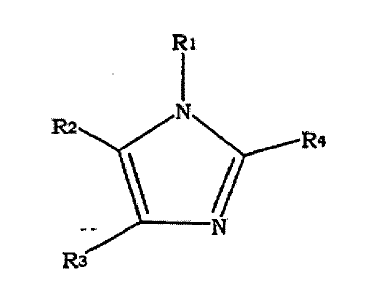 wobei jedes von "R₁" bis "R₄" ausgewählt ist aus Wasserstoffatom, Alkylgruppe mit einer Kohlenstoffanzahl von 1 bis 4, Hydroxymethylgruppe, Cyanogruppe, Cyanoalkylgruppe mit einer Kohlenstoffanzahl von 1 bis 4, Cyanoalkoxygruppe mit einer Kohlenstoffanzahl von 1 bis 4, Carboxylgruppe, Aminogruppe, Aminoalkylgruppe mit einer Kohlenstoffanzahl von 1 bis 4, Aminoalkoxygruppe mit einer Kohlenstoffanzahl von 1 bis 4, Phenylgruppe, Benzylgruppe, Phenylpropylgruppe und einer Formylgruppe.

16. Verfahren nach Anspruch 10, umfassend den Schritt der Bildung eines Schaltkreismusters in der Metallschicht durch Laser-Musterung.

## Revendications

1. Article moulé en résine à revêtement métallique comprenant un substrat fait d'une composition de résine et d'une couche métallique formée sur ledit substrat, dans lequel ladite composition de résine comprend un polyester cristallin-liquide et un groupe époxy contenant un copolymère d'éthylène,
ledit groupe époxy contenant un copolymère d'éthylène contient 50 à 99,9% en poids d'une unité d'éthylène et 0,1 à 30% en poids d'au moins l'une d'une unité d'ester de glycidyle d'acide carboxylique insaturé et d'une unité d'éther de glycidyle insaturé dans la molécule correspondante, et
une teneur dudit groupe époxy contenant un copolymère d'éthylène se trouve dans une gamme de 0,1 à 25 parties en poids par rapport à 100 parties en poids dudit polyester cristallin-liquide.

2. Article moulé en résine à revêtement métallique selon la revendication 1, dans lequel ledit polyester cristallin-liquide est un produit de réaction obtenu par un échange d'ester et une réaction de polycondensation d'au moins l'un d'un acide dicarboxylique aromatique et d'un acide hydrocarboxylique aromatique avec un composé acylé obtenu par l'acylation d'un groupe hydroxyle phénolique d'au moins l'un d'un diol aromatique et d'un acide hydroxycarboxylique aromatique avec un anhydride d'acide gras.

3. Article moulé en résine à revêtement métallique selon la revendication 1, dans lequel ledit polyester cristallin-liquide est le produit de réaction obtenu en effectuant l'échange d'ester et la réaction de polycondensation en présence d'un composé d'imidazole représenté par la formule chimique suivante : 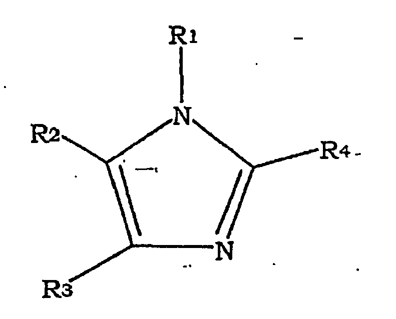 où, chacun de "R₁" à "R₄" est sélectionné parmi un atome d'hydrogène, un groupe alkyle ayant un nombre de carbone de 1 à 4, un groupe hydroxyméthyle, un groupe cyano, un groupe cyanoalkyle ayant un nombre de carbone de 1 à 4, un groupe cyanoalcoxy ayant un nombre de carbone de 1 à 4, un groupe carboxyle, un groupe aminé, un groupe aminoalkyle ayant un nombre de carbone de 1 à 4, un groupe aminoalcoxy ayant un nombre de carbone de 1 à 4, un groupe phényle, un groupe benzyle, un groupe phénylpropyle, et un groupe formyle.

4. Article moulé en résine à revêtement métallique selon la revendication 1, dans lequel ledit groupe époxy contenant un copolymère d'éthylène contient 80 à 95% en poids de l'unité d'éthylène et 5 à 15% en poids d'au moins l'une de l'unité d'ester de glycidyle d'acide carboxylique insaturé et de l'unité d'éther de glycidyle insaturé dans la molécule correspondante.

5. Article moulé en résine à revêtement métallique selon la revendication 1, dans lequel ladite composition de résine contient une charge inorganique en forme de fibre ayant un diamètre de 6 à 15 µm et un rapport de forme de 5 à 50.

6. Article moulé en résine à revêtement métallique selon la revendication 1, dans lequel ladite composition de résine contient 20 à 235 parties en poids d'une trichite par rapport à 100 parties en poids dudit polyester cristallin-liquide.

7. Article moulé en résine à revêtement métallique selon la revendication 1, dans lequel ladite composition de résine contient 10 à 40 parties en poids d'une charge inorganique en forme de plaque par rapport à 100 parties en poids dudit polyester cristallin-liquide.

8. Article moulé en résine à revêtement métallique selon la revendication 1, dans lequel ladite couche métallique est faite d'un matériau métallique sélectionné parmi le groupe se composant essentiellement de cuivre, de nickel, d'or, d'aluminium, de titane, de molybdène, de chrome, de tungstène, d'étain, de plomb, de laiton, de Nichrome et d'un alliage de ceux-ci.

9. Article moulé en résine à revêtement métallique selon la revendication 1, dans lequel ladite couche métallique est formée dans un motif de circuit.

10. Procédé de production d'un article moulé en résine à revêtement métallique comprenant les étapes qui consistent à :
mouler une composition de résine afin d'obtenir un substrat ; et
former une couche métallique sur une surface dudit substrat,
dans lequel ladite composition de résine comprend un polyester cristallin-liquide et un groupe époxy contenant un copolymère d'éthylène, ledit groupe époxy contenant un copolymère d'éthylène contient 50 à 99,9 % en poids d'une unité d'éthylène et 0,1 à 30% en poids d'au moins l'une d'une unité d'ester de glycidyle d'acide carboxylique insaturé et d'une unité d'éther de glycidyle insaturé dans la molécule correspondante, et une teneur dudit groupe époxy contenant un copolymère d'éthylène se trouve dans une gamme de 0,1 à 25 parties en poids par rapport à 100 parties en poids dudit polyester cristallin-liquide.

11. Procédé selon la revendication 10 comprenant l'étape qui consiste à effectuer un traitement par plasma à la surface dudit substrat avant la formation de ladite couche métallique.

12. Procédé selon la revendication 10, dans lequel ladite couche métallique est formée par un dépôt physique en phase vapeur.

13. Procédé selon la revendication 10 comprenant l'étape qui consiste à effectuer un traitement thermique audit substrat à une température entre une température limite inférieure calculée en soustrayant 120°C d'une température de début d'écoulement dudit polyester cristallin-liquide, et une température limite supérieure calculée en soustrayant 20°C de la température de début d'écoulement.

14. Procédé selon la revendication 10, dans lequel ledit polyester cristallin-liquide est préparé par un échange d'ester et une réaction de polycondensation d'au moins l'un d'un acide dicarboxylique aromatique et d'un acide hydroxycarboxylique aromatique, avec un composé acylé obtenu par l'acylation d'un groupe hydroxyle phénolique d'au moins l'un d'un diol aromatique et d'un acide hydroxycarboxylique aromatique avec un anhydride d'acide gras.

15. Procédé selon la revendication 14, dans lequel l'échange d'ester et la réaction de polycondensation sont effectués en présence d'un composé d'imidazole représenté par la formule chimique suivante : 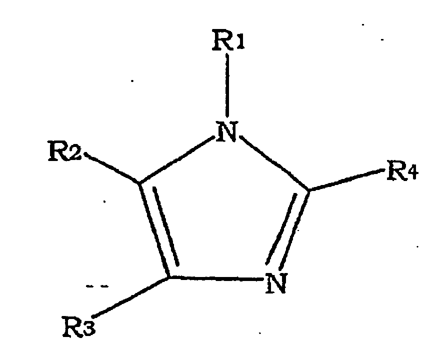 où, chacun de "R₁" à "R₄" est sélectionné parmi un atome d'hydrogène, un groupe alkyle ayant un nombre de carbone de 1 à 4, un groupe hydroxyméthyle, un groupe cyano, un groupe cyanoalkyle ayant un nombre de carbone de 1 à 4, un groupe cyanoalcoxy ayant un nombre de carbone de 1 à 4, un groupe carboxyle, un groupe aminé, un groupe aminoalkyle ayant un nombre de carbone de 1 à 4, un groupe aminoalcoxy ayant un nombre de carbone de 1 à 4, un groupe phényle, un groupe benzyle, un groupe phénylpropyle, et un groupe formyle.

16. Procédé selon la revendication 10 comprenant l'étape qui consiste à former un motif de circuit dans ladite couche métallique par une formation de motifs par laser.
